# EUROPEAN PATENT SPECIFICATION

(11) **EP 4 157 799 B1**
(45) Date of publication and mention of the grant of the patent: **08.01.2025**
(21) Application number: 21733380.6
(22) Date of filing: 28.05.2021
(51) Int. Cl.: A44C 17/00, A44C 27/00, B05D 1/00, B44C 1/00, C03C 17/28, C03C 17/32, C09D 11/033, C09D 11/101, C08G 77/16, C08G 77/20, C23C 16/50, C03C 17/30, C08F 2/44, C08F 2/46, C08F 2/52, C09D 183/04, C23C 16/448

(54) **METHOD OF PROVIDING A COLOUR COATING ON A DECORATIVE ELEMENT**
VERFAHREN ZUM AUFBRINGEN EINER FARBBESCHICHTUNG AUF EIN DEKORATIVES ELEMENT
PROCÉDÉ DE FOURNITURE D'UN REVÊTEMENT DE COULEUR SUR UN ÉLÉMENT DÉCORATIF

(30) Priority: 28.05.2020 EP 20177265
(43) Date of publication of application: 05.04.2023
(73) Proprietor: D. Swarovski KG, 6112 Wattens (AT)
(72) Inventor: HEINEMANN, Michael, 6166 Fulpmes (AT)
(74) Representative: Keltie LLP
(86) International application number: PCT/EP2021/064444
(87) International publication number: WO 2021/239994

(56) References cited:
- EP-A1- 2 281 916
- US-B2- 8 431 188
- NICOLAS D. BOSCHER ET AL: "Luminescent lanthanide-based hybrid coatings deposited by atmospheric pressure plasma assisted chemical vapour deposition", JOURNAL OF MATERIALS CHEMISTRY, vol. 21, no. 47, 1 January 2011 (2011-01-01), pages 18959, XP055020086, ISSN: 0959-9428, DOI: 10.1039/c1jm14659a

## Description

The invention relates to a method of providing a colour coating on a decorative element such as a gemstone.

### Introduction

Decorative elements such as gemstones are typically produced in a wide variety of colours. Where the gemstones are made of glass, additives may be introduced into the glass composition to provide colour throughout the entire bulk of the glass. The additives may be tuned to provide any colour that is desired, and manufacturer often have a catalogue of available colours.

For consistent quality, it is important that all gemstones having a particular colour chosen from the catalogue will have exactly the same colour appearance to an observer. However, when bulk glass is coloured using additives, the size and shape of a gemstone can impact how a colour is perceived by an observer. If gemstones of different sizes use an identical additive composition, they will appear to an observer to show slightly different shades or intensities of the same colour depending on their size and shape. For that reason, the additive mixture must be adapted for different sizes and shapes of gemstone to produce an identical colour effect.

Bulk colouring of glass gives a consistent, intense and durable colour effect that provides a high-quality product. However, it is typically only economical to produce a particular glass composition in a relatively large quantity. For that reason, it is generally unfeasible to produce gemstones of a particular colour, size and shape in small volumes. This means production can be limited to a specific number of colours, and 'bespoke' colours cannot be typically produced in small batches.

US 8431188 B2 discloses a method of imparting an abrasion resistant coloured coating to gemstones using an integrated coating that includes a colour imparting agent, which may rely on optical effects such as Fresnel reflection, volume absorption and light dispersion, and an abrasion wear resistant agent, such as diamond-like carbon, CVD diamond, alumina, nitrides and carbonitrides.

It would be desirable to find alternative means of colouring gemstones made from materials such as glass that retains at least some of the benefits of bulk glass colouring, while avoiding at least some of the drawbacks.

### Statements of invention

Against this background, the invention resides in a method of applying a coloured coating to a decorative element comprising glass or a glass ceramic. The method comprises: providing an ink mixture comprising an ink and an organic carrier, the carrier comprising a polymerisable silane- or silyl-acrylate and the ink comprising a colour-imparting organic compound in solution, wherein a volumetric ratio of the ink to the carrier is between 1:1 and 1:100; arranging the ink mixture and the decorative element in a plasma; and allowing the ink mixture to polymerise on a surface of the decorative element to form a polymerised colour coating.

The polymerisable silane or silyl-acrylate is particularly advantageous if the decorative element is made of a glass such as a silica glass, since the resulting polymerised colour coating comprises an Si-containing matrix that is particularly compatible with the silica glass.

For example, the carrier may comprise 3-(Trimethoxysilyl)propyl methacrylate. It will be appreciated that a silyl- acrylate includes any acrylate that comprises a silyl group, including any silyl (organo)acrylate. This includes for example silyl (meth)acrylates such as (Trimethoxysilyl)oragno methacrylates (where organo' refers to the organic linker connecting the silyl moiety to the acrylate moiety and is for example alkyl, propyl, ethyl, methyl etc), including the above mentioned 3-(Trimethoxysilyl)propyl methacrylate. It also includes silyl (ethyl)acrylates. Similarly a silane-acrylate includes any acrylate that comprises a silane group.

The step of providing the ink mixture may comprises mixing the ink and the carrier.

Alternatively, the ink mixture may be provided as a pre-mixed mixture.

The colour-imparting organic compound may be a metal organic compound.

The ink may comprise a polar organic solvent, and the colour-imparting organic compound may be dissolved in the polar organic solvent. The polar organic solvent may comprise an ester derived from a carboxylic acid, preferably a glycol ester.

A volumetric ratio of the ink to the carrier may be between 1:2 and 1:100 preferably 1:4.

The method may comprise aerosolising the ink mixture and arranging the aerosolised ink mixture in the plasma.

For example, the step of arranging the aerosolised ink mixture in the plasma may comprise providing a plasma chamber, creating a plasma inside the plasma chamber, and arranging the aerosolised mixture in the chamber.

The method may comprise aerosolizing the ink mixture using an ultrasonic device and/or an atomizer.

Preferably, the ink mixture is aerosolized so as to produce droplets having a diameter of less than approximately 1 micron. To this end, where an ultrasonic device is used, the method preferably comprises using the ultrasonic device at a frequency of approximately 17 MHz.

The polymerised colour coating may comprise a polymer matrix having ink embedded therein, the polymer matrix being at least partially transparent. Partially transparent may mean that a portion of incident light is transmitted while a portion is absorbed or reflected (i.e. the polymer matrix is translucent) or it may mean that a region of the coating is fully transparent (i.e. all incident light is transmitted) while another part is not fully transparent (i.e. some incident light is reflected or absorbed).

The polymer matrix may comprise a polymer having an oxysilane or a siloxane bond.

The decorative element may comprise a body that is at least partially transparent. The body may comprise a silica glass or a silica glass ceramic.

The decorative element may be a gemstone. The gemstone may be faceted.

The invention also extends to a decorative element made using the method described above.

### Detailed Description

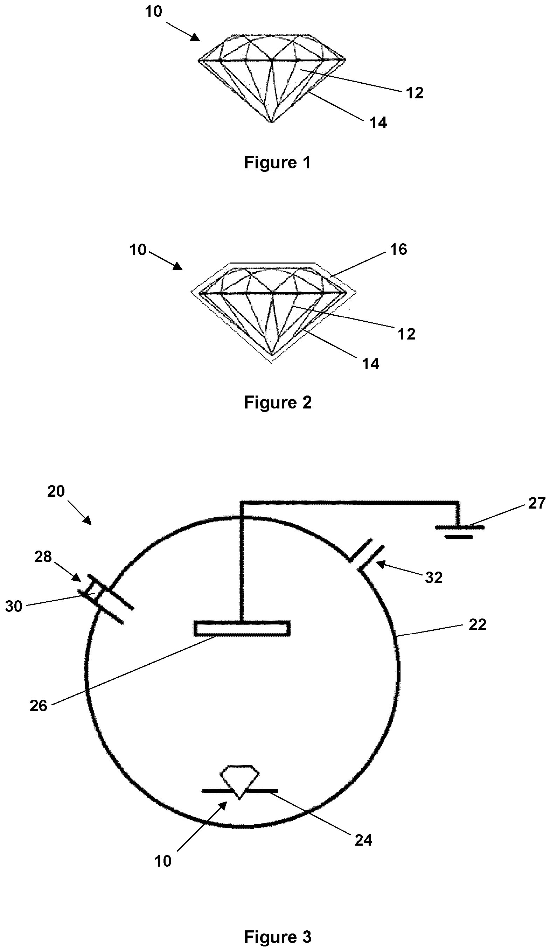

Figure 1 illustrates a decorative element 10: in this example, a faceted gemstone comprising a body 12 made of a substantially colourless glass. Figure 2 illustrates the same decorative element 10 with a coloured coating 14 covering its outer surface 16. The coloured coating 14 is applied over the entire surface, and provides a colour effect, such that even though the body 12 is colourless the gemstone 10 appears coloured. The coloured coating 14 is at least partially transparent, to allow the gemstone to refract light, providing a sparkling appearance.

In this example the body 12 of the gemstone 10 is made of colourless glass, and specifically of a quartz or silica glass comprising up to 85% by weight SiO₂, with other oxide additions. However, in other examples, the glass may be a different glass, for example a borosilicate glass, a borate glass or a phosphate glass. The body 12 of the gemstone 10 may also be made of a coloured glass, so that the colour effect of the coating 14 overlays the colour effect of the body 12 to produce a combined colour effect.

The coating 14 is applied to the gemstone 10 using a plasma-assisted polymerisation method, as will now be described.

First, an ink mixture is created that will act as a precursor material for forming the coating 14. To create the ink mixture, an ink is mixed with an organic carrier material. The ink and the carrier material are dissolved together such that the ink mixture is a solution. This is in contrast to a mixture that is a suspension.

The ink mixture is then aerosolised, and the gemstone 10 and the aerosolised ink mixture are arranged in a plasma atmosphere, for example inside a plasma deposition chamber. The ink mixture is deposited on the surface 16 of the gemstone 10 and polymerises to form the coloured coating 14.

Considering the components of the ink mixture in more detail:
The ink is an organic ink and comprises a colour imparting material in the form of one or more organic or metal organic compounds, and a polar organic solvent. The organic or metal organic compounds may vary according to the colour of the ink. Any desired colour can be produced by mixing different inks together. The polar organic solvent may be any suitable polar organic solvent, and for example may be an ester of a carboxylic acid, such as glycol ester. A particularly suitable ink is a SB.Gi. 1000, 2000 or 3000 ink commercially available from STS^{®}.

The carrier is an organic material that is capable of polymerisation. The carrier is a silicon-containing polymerisable material, and is specifically a polymerisable silane or siloxane, such as a polymerisable silane- or silyl- acrylate.

For example, the carrier may be 3-(Trimethoxysilyl)propyl methacrylate, commercially available from Merck under designation A174, with the following chemical formula:

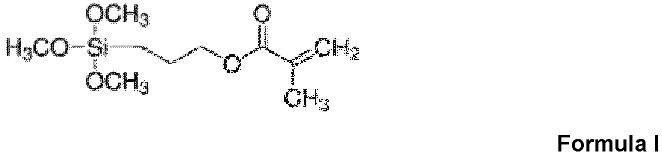

The carrier and the ink are selected such that when the two components are mixed together, they form a solution rather than a suspension. Where the carrier is 3-(Trimethoxysilyl)propyl methacrylate, using an ink based on a polar organic solvent assists in forming the solution. However, it should be appreciated that for different carrier materials, different ink solvents could be appropriate for forming a solution.

The ink and the carrier are mixed in a proportion that is selected to provide the appropriate colour intensity in the deposited colour layer 14. The ratio of the ink to the carrier is between 1:1 and 1:100, and is preferably 1:4.

The ink mixture is aerosolised using any suitable aerosolization method, for example using an ultrasound device or using a combination of an ultrasound device and an atomiser, such as a Venturi atomiser. Preferably, the aerosolised droplets have a diameter of less than 1 micron: this droplet size is preferred to provide a uniform coating on the gemstone 10. To achieve this droplet size, the ultrasound device is set to a frequency of 1.7 MHz. Where an atomiser is used, an atomisation gas is employed, which may be for example nitrogen or argon.

The plasma-assisted deposition step takes place using a plasma deposition apparatus 20, which is show schematically in Figure 3.

The apparatus 20 is a standard plasma deposition apparatus and comprises a sealable chamber 22 that contains a gemstone support 24 and a carbon electrode 26. The electrode 26 is connected to a voltage supply 27, so that a potential difference can be created between the electrode 26 and the gemstone 10, thereby creating a plasma jet that causes deposition on the surface of the gemstone 10.

A first opening in the chamber 22 defines an inlet 28 through which the aerosolised ink mixture may be introduced into the chamber. Aerosolisation apparatus 30 may be provided in or near the inlet 28 to aerosolise the ink mixture on entry to the chamber 22. The position of the inlet 28 may be optimised, so that the aerosolised ink mixture is fed to an optimum location relative to the plasma jet.

A second opening in the chamber 22 defines an opening 32 through which the chamber 22 may be evacuated and/or through which gases such as argon, nitrogen and oxygen may be introduced into the chamber 22 if required.

To deposit the coloured coating 14 on the gemstone 10, a plasma atmosphere is created in the chamber 22 by creating a potential difference between the gemstone support 24 and the electrode 26. Aerosolised ink mixture is then introduced into the chamber 22 and the plasma stream via the inlet 28. The ink mixture is deposited on the gemstone 10 and polymerises to form the coating.

As will be appreciated by one skilled in the art, a plasma atmosphere is any environment in which matter is present in a plasma state (i.e. a gas of ions). Any appropriate parameters may be used to generate the plasma state, and the atmosphere inside the chamber may be at any pressure, temperature or other parameter that is sufficient to sustain a plasma within the chamber.

The energy of the plasma is controlled by tuning the potential difference between the electrode and the holder, and hence by tuning the power supplied to the electrode. In particular, the plasma energy is selected to be sufficiently high that the carrier material can polymerise, but not so high that the organometallic of the ink decomposes, which would otherwise affect the colour of the coloured layer. A power of between 50 W and 500 W is appropriate depending on the exact materials selected for the ink and the carrier material.

When the ink mixture polymerises on the surface of the gemstone, the carrier material forms a polymer matrix that is at least partially transparent. The exact material of the polymer matrix will depend upon the initial carrier material. Where the carrier is a silicon-containing material, the polymer matrix will comprise a polymer that includes silicon. Where the carrier comprises a polymerisable silane or siloxane, the polymer matrix will include a poly-silane or polysiloxane. Where the carrier comprises a polymerisable silyl acrylate, the matrix will comprise a poly silyl- acrylate. A silicon-containing polymer matrix may be particularly compatible with a decorative element that is made of silica glass.

The ink material is trapped within the polymer matrix during polymerisation, and gives the coloured appearance to the coloured layer 14. Because the initial ink mixture was a solution, with ink evenly dissolved in the carrier, the ink material is correspondingly evenly dispersed within the matrix, giving intense, even colour in the coloured layer 14.

Because the coloured layer 14 is a polymer material that has been polymerised directly onto the body 12 of the gemstone 10, the layer 14 has a good adherence to the gemstone 10, and has a high scratch resistance and impact resistance.

The layer therefore provides a consistent and intense colour coating that has good durability. The resulting gemstone therefore gives the appearance of being a coloured gemstone, despite the fact that the body 12 of the gemstone 10 is colourless and the colour is provided only by the coating 14.

By using appropriate ink mixtures, any desired colour can be created on the gemstone 10. The simple plasma-assisted deposition process means that small batches of ink mixture of a particular colour can made and applied to small batches of gemstones in an economic and process. In this way, it is possible to produce small batches of gemstones of bespoke colours in a cost-effective manner.

Although in the embodiments described above the decorative element is a faceted gemstone, it should be appreciated that the decorative element need not be a faceted gemstone. For example, the decorative element may be any component that is capable of being attached or coupled to an article to perform a decorative function. Examples other than a faceted gemstone include a pearl or bead, or a gemstone of a rounded cut such as a cabochon. The decorative element need not be made of glass but may be made of any suitable material that is compatible with the coating, for example a glass ceramic.

### Example

An ink mixture was made by mixing an STS ink with a carrier in the form of 3-(Trimethoxysilyl)propyl methacrylate (Merck A174) with an ink : carrier ratio of 1 : 4. The components were mixed until dissolved.

The ink mixture was applied to a glass slide to wet the surface of the slide.

The glass slide was arranged inside a plasma chamber, with the slide at a distance of 85 mm from the plasma source.

A voltage was applied to the plasma source to create a plasma atmosphere inside the chamber. In a first example, the plasma parameters were 13,56 MHz and 800W, and in a second example the plasma parameters were 2,45 GHz and 700W.

In both examples, the mixture polymerized on the glass slide to produce a polymerized colour coating having a uniform colour, with good adhesion to the glass slide.

## Claims

1. A method of applying a coloured coating to a decorative element comprising glass or a glass ceramic, the method comprising:
providing an ink mixture comprising an ink and an organic carrier, the carrier comprising a polymerisable silane- or silyl-acrylate and the ink comprising a colour-imparting organic compound in solution, wherein a volumetric ratio of the ink to the carrier is between 1:1 and 1:100;
arranging the ink mixture and the decorative element in a plasma; and
allowing the ink mixture to polymerise on a surface of the decorative element to form a polymerised colour coating.

2. The method of Claim 1, wherein the carrier comprises 3-(Trimethoxysilyl)propyl methacrylate.

3. The method of Claim 1 or Claim 2, wherein the ink comprises a metal organic compound.

4. The method of any preceding claim, wherein the ink comprises a polar organic solvent.

5. The method of Claim 4, wherein the solvent comprises an ester derived from a carboxylic acid.

6. The method of Claim 5, wherein the solvent comprises a glycol ester.

7. The method of any preceding claim, wherein a volumetric ratio of the ink to the carrier is between 1:2 and 1:100.

8. The method of Claim 7, wherein the volumetric ratio of the ink to the carrier is 1:4

9. The method of any preceding claim, comprising aerosolising the ink mixture and arranging the aerosolised ink mixture in the plasma.

10. The method of Claim 9, comprising aerosolizing the ink mixture using an ultrasonic device and/or an atomizer.

11. The method of any preceding claim, wherein the polymerised colour coating comprises a polymer matrix having ink embedded therein, the polymer matrix comprises a polymer having an oxysilane or a siloxane bond.

12. The method of any preceding claim wherein the decorative element is a gemstone.

## Patentansprüche

1. Verfahren zum Aufbringen einer gefärbten Beschichtung auf ein dekoratives Element, das Glas oder eine Glaskeramik umfasst, wobei das Verfahren umfasst:
Bereitstellen einer Tintenmischung, die eine Tinte und einen organischen Träger umfasst, wobei der Träger ein polymerisierbares Silan- oder Silylacrylat umfasst und die Tinte eine farbgebende organische Verbindung in Lösung umfasst, wobei ein Volumenverhältnis der Tinte zum Träger zwischen 1:1 und 1:100 liegt;
Anordnen der Tintenmischung und des dekorativen Elements in einem Plasma; und
Polymerisierenlassen der Tintenmischung auf einer Oberfläche des dekorativen Elements, um eine polymerisierte Farbschicht zu bilden.

2. Verfahren nach Anspruch 1, wobei der Träger 3-(Trimethoxysilyl)propylmethacrylat umfasst.

3. Verfahren nach Anspruch 1 oder Anspruch 2, wobei die Tinte eine metallorganische Verbindung umfasst.

4. Verfahren nach einem der vorstehenden Ansprüche, wobei die Tinte ein polares organisches Lösungsmittel umfasst.

5. Verfahren nach Anspruch 4, wobei das Lösungsmittel einen von einer Carbonsäure abgeleiteten Ester umfasst.

6. Verfahren nach Anspruch 5, wobei das Lösungsmittel einen Glykolester umfasst.

7. Verfahren nach einem der vorstehenden Ansprüche, wobei ein Volumenverhältnis der Tinte zum Träger zwischen 1:2 und 1: 100 liegt.

8. Verfahren nach Anspruch 7, wobei das Volumenverhältnis der Tinte zum Träger 1:4 beträgt.

9. Verfahren nach einem der vorstehenden Ansprüche, umfassend das Vernebeln der Tintenmischung in Aerosolform und das Anordnen der vernebelten Tintenmischung im Plasma.

10. Verfahren nach Anspruch 9, umfassend das Vernebeln der Tintenmischung in Aerosolform unter Verwendung einer Ultraschallvorrichtung und/oder eines Zerstäubers.

11. Verfahren nach einem der vorstehenden Ansprüche, wobei die polymerisierte Farbbeschichtung eine Polymermatrix mit darin eingebetteter Tinte umfasst, wobei die Polymermatrix ein Polymer mit einer Oxysilan- oder einer Siloxanbindung umfasst.

12. Verfahren nach einem der vorstehenden Ansprüche, wobei das dekorative Element ein Edelstein ist.

## Revendications

1. Procédé d'application d'un revêtement coloré sur un élément décoratif comprenant du verre ou une vitrocéramique, le procédé comprenant :
l'aménagement d'un mélange d'encre composé d'une encre et d'un support organique, le support comprenant un acrylate de silane ou de silyle polymérisable, et l'encre comprenant un composé organique colorant en solution, un rapport volumétrique de l'encre sur le support étant compris entre 1/1 et 1/100 ;
l'agencement du mélange d'encre et de l'élément décoratif dans un plasma ; et
l'accomplissement de la polymérisation du mélange d'encre sur une surface de l'élément décoratif afin de former un revêtement coloré polymérisé.

2. Procédé selon la revendication 1, le support comprenant du 3-(triméthoxysilyl) propylique méthacrylate.

3. Procédé selon la revendication 1 ou la revendication 2, l'encre comprenant un composé organique métallique.

4. Procédé selon une quelconque des revendications précédentes, l'encre comprenant un solvant organique polaire.

5. Procédé selon la revendication 4, le solvant comprenant un ester dérivé d'un acide carboxylique.

6. Procédé selon la revendication 5, le solvant comprenant un glycol ester.

7. Procédé selon une quelconque des revendications précédentes, un rapport volumétrique de l'encre sur le support étant compris entre 1/2 et 1/100.

8. Procédé selon la revendication 7, le rapport volumétrique de l'encre sur le support étant égal à 1/4.

9. Procédé selon une quelconque des revendications précédentes, comprenant l'aérosolisation du mélange d'encre et l'aménagement du mélange d'encre aérosolisée dans le plasma.

10. Procédé selon la revendication 9, comprenant l'aérosolisation du mélange d'encre à l'aide d'un appareil à ultrasons et/ou d'un atomiseur.

11. Procédé selon une quelconque des revendications précédentes, le revêtement coloré polymérisé comprenant une matrice polymère dans laquelle est intégrée de l'encre, la matrice polymère comprenant un polymère comportant une liaison oxysilane ou siloxane.

12. Procédé selon une quelconque des revendications précédentes, l'élément décoratif étant une pierre précieuse.
